# EUROPÄISCHE PATENTSCHRIFT

(11) **EP 4 163 739 B1**
(45) Veröffentlichungstag und Bekanntmachung des Hinweises auf die Patenterteilung: **31.01.2024**
(21) Anmeldenummer: 22199326.4
(22) Anmeldetag: 03.10.2022
(51) Int. Cl.: G05B 9/03

(54) **VERFAHREN ZUR ÜBERWACHUNG EINER ELEKTRISCHEN SCHALTANORDNUNG**
METHOD FOR MONITORING AN ELECTRICAL SWITCHING ASSEMBLY
PROCÉDÉ DE SURVEILLANCE D'UN AGENCEMENT DE COMMUTATION ÉLECTRIQUE

(30) Priorität: 05.10.2021 AT 507952021
(43) Veröffentlichungstag der Anmeldung: 12.04.2023
(73) Patentinhaber: B&R Industrial Automation GmbH, 5142 Eggelsberg (AT)
(72) Erfinder: HERZOG, Marc, 5142 Eggelsberg (AT); KLEINEBERG, Matthias, 5142 Eggelsberg (AT)
(74) Vertreter: Patentanwälte Pinter & Weiss OG

(56) Entgegenhaltungen:
- EP-A2- 2 733 718
- WO-A1-2011/061345
- DE-A1-102018 200 120

## Beschreibung

Die gegenständliche Erfindung betrifft ein Verfahren zur Überwachung einer elektrischen Schaltanordnung mit zumindest zwei Kanälen, welche jeweils eine den jeweiligen Kanal versorgende elektrische Quelle unter Ausbildung einer elektrischen Versorgungsgröße mit einem Ausgang des jeweiligen Kanals elektrisch leitend verbinden, wobei der Schaltanordnung ein externes Sicherheitssignal zugeführt wird, aus welchem für die zumindest zwei Kanäle jeweils ein internes Sicherheitssignal erzeugt wird, um damit einen seriell in den jeweiligen Kanal geschalteten Spannungsunterbrecher anzusteuern.

Die stete Zunahme der Komplexität moderner technischer Systeme, sei es auf dem Gebiet der Transportlogistik, der Industrieautomation oder auch der Personenbeförderung, führt zu einer fortlaufend wachsenden Zahl an Fragestellungen im Bereich der funktionalen Sicherheit. Funktionale Sicherheit zielt hierbei als funktionaler Bestandteil von Sicherheitskonzepten von technischen Systemen darauf ab, Mensch und/oder Umwelt vor Fehlfunktionen eines technischen Systems zu schützen. Üblicherweise werden dabei in einem Sicherheitskonzept zunächst zu schützende Objekte und/oder zu verfolgende Schutzziele festgelegt, darauf aufbauend mögliche Schadensszenarien, Fehlfunktionen und/oder Gefahren analysiert, in einem weiteren Schritt deren Eintrittswahrscheinlichkeit bewertet, und abschließend Maßnahmen und Handlungsabläufe, sogenannte "Sicherheitsfunktionen", geplant, die im Fall eines Eintretens eines Schadensszenarios, einer Fehlfunktionen oder einer Gefahr mit dem Ziel der Schadensbekämpfung und/oder - eindämmung ausgeführt werden.

Für technische Systeme, in denen elektrische Antriebe oder elektrische Antriebselemente oder elektrische Antriebssysteme zur Lösung von technischen Aufgaben eingesetzt werden, sind in der Norm EN IEC 61800-5-2:2007 eine Vielzahl von Sicherheitsfunktionen definiert. Gemäß dieser Norm beschreibt die Sicherheitsfunktion STO ("Safe torque off") für den Fall einer Gefahrensituation eine sofortige Unterbrechung der Energieversorgung der im zu schützenden System gegebenen Antriebe, wobei die Antriebe ungesteuert stillgesetzt werden. Ein Antrieb kann nach einer STO-gemäßen Abschaltung kein Drehmoment, und demnach auch kein Bremsmoment mehr erzeugen. Gegebenenfalls nötige Bremsungen werden im Rahmen von STO üblicherweise anhand gesonderter Maßnahmen oder Mittel, z.B. anhand von mechanischen Bremsen, durchgeführt, damit kein unerwünschter Nachlauf oder ein Überschreiten von vorgegebenen Endlagen, beispielsweise durch eine Antriebsachse, erfolgt. Typische Anwendungsfälle der Sicherheitsfunktion STO umfassen das Abschalten eines elektrischen Umrichters oder die Durchführung eines durch einen Hauptschalter mit Notaus-Funktion ausgelösten Notstopps.

Die Sicherheitsfunktion SS1 ("Safe stop 1") beschreibt demgegenüber eine geregelte Überführung eines Antriebs in den Stillstand und erst anschließend eine Aktivierung von STO. Eine weitere wichtige Sicherheitsfunktion ist SS2 ("Safe stop 2"), bei der die zu überwachenden Antriebe geregelt in den Stillstand versetzt werden, darin im Anschluss jedoch unter aufrecht erhaltener Energieversorgung verbleiben. Der Stillstand wird hierbei überwacht.

Neben den genannten Sicherheitsfunktionen STO, SS1 und SS2 beschreibt die EN IEC 61800-5-2:2007 weiters die Funktionen SOS ("Safe operating stop"), SLS ("Safely limited speed"), SSM ("Safe speed monitor"), SSR ("Safe speed range"), SLP ("Safe limited position"), SP ("Safe position"), *SDI* ("Safe direction") und *SBC*/*SBT* ("Safe brake control, Safe brake test").

Zur Klassifizierung der genannten Sicherheitsfunktionen wurden sogenannte Stopp-Kategorien definiert, von denen die *Stopp-Kategorie* 0 eine sofortige Trennung der Energiezufuhr zu einem Antrieb beschreibt und demnach das eingangs erwähnte STO umfasst. *Stopp-Kategorie* 1 steht demgegenüber für ein gesteuertes Stillsetzen, wobei ein gegebener Antrieb zuerst in einen sicheren Zustand versetzt wird und erst anschließend dessen Energieversorgung getrennt wird. Unter anderem fällt die Sicherheitsfunktion SS1 in die Stopp-Kategorie 1. Weiters ist die *Stopp-Kategorie* 2 zu nennen, in die Sicherheitsfunktionen fallen, bei denen Antriebe oder Maschinen nur in einen sicheren Zustand versetzt werden, die Energieversorgung aber nicht getrennt wird. Ein Beispiel dafür ist die Sicherheitsfunktion SS2.

Ungeachtet der konkret gewählten Sicherheitsfunktion ist für die Umsetzung eines Sicherheitskonzeptes bzw. einer darin definierten Sicherheitsfunktion zunächst die Detektion von Schadensszenarien, von Gefahren und generell von Fehlfunktionen wesentlich, nach deren Eintreten eine vorgegebene Sicherheitsfunktion gestartet und ausgeführt werden soll. Für eine derartige Detektion werden üblicherweise geeignete Sicherheitssensoren und/oder geeignete Sicherheitsschalter eingesetzt, wie z.B. Lichtschranken und/oder Notausschalter und/oder Sicherheitslichtgitter. Sicherheitssensoren werden in diesem Zusammenhang auch als sichere Ausgangselemente bezeichnet. Bevorzugt kommunizieren Sicherheitssensoren anhand sogenannter Sicherheitssignale mit sogenannten sicheren Schaltanordnungen, beispielsweise in Form einer Steuereinheit eines zu überwachenden technischen Systems, wobei derartige sichere Schaltanordnungen üblicherweise in der Lage sind, eine der oben genannten Sicherheitsfunktionen auszulösen und in der Folge deren Durchführung sicherzustellen.

Wird von einem Sicherheitssensor eine Gefahrensituation erkannt, teilt der Sicherheitssensor dies einer sicheren Schaltanordnung üblicherweise anhand eines Sicherheitssignals mit, beispielsweise durch eine Pegeländerung des Sicherheitssignals, worauf die Steuereinheit eine der eingangs genannten Sicherheitsfunktionen auslösen kann. Sichere Schaltanordnungen, die wie eine Steuereinheit Sicherheitssignale empfangen können, werden in diesem Zusammenhang insbesondere auch als sichere Empfangselemente bezeichnet. Von einem Sicherheitssensor abgegebene Sicherheitssignale werden demgegenüber oft nach der gewählten und auszulösenden Sicherheitsfunktion benannt, im Fall von STO ist beispielsweise die Bezeichnung "STO-Signale" üblich. Im Zuge der nachfolgenden Ausführungen wird überdies vom allgemeinen Begriff "Sicherheitskomponente" Gebrauch gemacht, um die oben genannten, sicherheitstechnischen Komponenten außerhalb eines sicheren Empfangselements, wie Sicherheitssensoren, Schutzschalter oder Kabel zu deren Verbindung, pauschal zu bezeichnen.

Neben der reinen Detektion von Schadensszenarien, von Gefahren und allgemein von Fehlfunktionen ist bei der Implementierung von Sicherheitsfunktionen ebenso auf eine Überwachung der verwendeten Sicherheitssensoren selbst, deren Signalleitungen beispielsweise zu einer Steuereinheit selbst, und insgesamt der eingesetzten Sicherheitskomponenten selbst, zu achten. So ist es vielfach von wesentlicher Bedeutung, mit Gewissheit ausschließen zu können, dass es nicht aufgrund eines Kabelbruchs oder eines sonstigen Gebrechens einer Sicherheitskomponente zu Beeinträchtigungen bei der Übermittlung einer Detektion einer Gefahrensituation kommen kann.

Zu diesem Zweck haben sich im Wesentlichen zwei Ansätze hervorgetan. In einem ersten Ansatz wird diesbezüglich auf eine redundante Ausführung von Sicherheitskomponenten gesetzt. Dieser Zugang ist jedoch meist mit einem erhöhten Material- und Kostenaufwand verbunden und deshalb in vielen Fällen nachteilig. In einem zweiten Ansatz wird demgegenüber auf eine im Betrieb eines zu überwachenden technischen Systems fortlaufend durchgeführte Überwachung/Diagnose/Testung von Sicherheitskomponenten gesetzt. Der Gedanke hierbei ist, mögliche Fehler in den gegebenen Sicherheitskomponenten selbst möglichst unmittelbar zu erkennen, und im Fall einer derartigen Erkenntnis geeignet zu reagieren, beispielsweise durch das Auslösen wiederum einer Sicherheitsfunktion.

Eine wichtige Methode zur Umsetzung des zweiten Ansatzes basiert auf der Verwendung von sogenannten Diagnosesignalen, beispielsweise in Form von OSSD-Testpulsen ("Output signal switching device"-Testpulsen). In den üblichen Fällen stellen Diagnosesignale, wie insbesondere in Form von OSSD-Testpulsen, im Vergleich zu den genannten Sicherheitssignalen höherfrequente Signale dar. Diagnosesignale werden gegebenen Sicherheitssignalen vielfach überlagert, um entsprechend ihrer Frequenz in den Sicherheitssignalen gepulste Pegeländerungen herbeizuführen. Eine Voraussetzung für die Verwendung von Diagnosesignalen, insbesondere in Form von OSSD-Testpulsen, ist, dass deren Überlagerung auf ein Sicherheitssignal die mit diesem verknüpften Sicherheitsfunktionen nicht beeinträchtigt. Ist diese Voraussetzung gegeben, werden Diagnosesignale oder mit Diagnosesignalen überlagerte Sicherheitssignale üblicherweise in eine zu testende Sicherheitskomponente, wie ein Kabel zur Verbindung eines Sicherheitssensors mit einer Steuereinheit, über einen Eingang der zu testenden Sicherheitskomponenten als Eingangs-Diagnosesignale eingeleitet.

In einem weiteren Schritt wird an einem mit dem Eingang elektrisch verbundenen Ausgang der zu testenden Sicherheitskomponente eine Messung des dort ankommenden Ausgangs-Diagnosesignals durchgeführt. Dabei wird kontrolliert, ob das Eingangs-Diagnosesignal in einer erwarteten Form zum Ausgang übertragen worden ist. In den üblichen Fällen erlaubt eine hinreichende Übereinstimmung von derartigen Eingangs- und Ausgangs-Diagnosesignalen den Schluss auf die funktionale Integrität der getesteten Sicherheitskomponente. Weichen Eingangs- und Ausgangs-Diagnosesignal jedoch voneinander ab, kann auf einen Defekt geschlossen werden und demnach eine Sicherheitsfunktion ausgelöst werden. Diagnosesignale werden bevorzugt von Sicherheitssensoren, also von sicheren Ausgangselementen, selbst erzeugt.

Diagnosesignale im Allgemeinen und OSSD-Testpulse, die von einem sicheren Ausgangselement erzeugt werden, im Speziellen können beispielsweise zur Detektion von Kurzschlüssen und/oder Querschlüssen in Kabeln verwendet werden. Natürlich können auch Fehler unmittelbar an einem sicheren Ausgangselement oder am Eingang eines Empfangselements erkannt werden. Entsprechend ihrer gepulsten Form umfassen OSSD-Testpulse hohe Pegel (OSSD-Highpulse) und niedrige Pegel (OSSD-Lowpulse). OSSD-Lowpulse werden dabei vielfach am Eingang eines sicheren Empfangselements weggefiltert; einerseits, da deren primärer Zweck die Testung von externen Sicherheitskomponenten außerhalb Empfangselements ist, andererseits, um sichere Empfangselemente nicht durch hochfrequente OSSD-Testpulse zu stören. Typische Werte für OSSD-Testpulse sind beispielsweise eine Pulsdauer von ≤ 1,0 ms und eine Periodendauer ≥ 500 ms.

Entsprechend den obigen Ausführungen und den beiden dargestellten Ansätzen können im Bereich der funktionalen Sicherheit zum Erreichen eines hohen Sicherheitslevels bzw. einer geringen Wahrscheinlichkeit für gefahrbringende Fehler entweder möglichst viele Sicherheitskomponenten redundant ausgeführt werden, oder diese fortlaufend während ihres Betriebs getestet bzw. diagnostiziert werden. Die Güte derartiger Testungen bzw. Diagnosen wird vielfach anhand des sogenannten Diagnosedeckungsgrades ("DC-Wertes") beschrieben. Der Diagnosedeckungsgrad stellt dabei die Summe aller erkannten gefahrbringenden Ausfälle im Verhältnis zur Gesamtzahl aller gefahrbringenden Ausfälle dar. Werden weniger Schaltungsteile redundant ausgeführt, kann es erforderlich werden, eine größere Zahl an Sicherheitskomponenten zu überwachen / zu diagnostizieren, um den gleichen sicherheitstechnischen Anforderungen gerecht zu werden. Sicherheitstechnische Anforderungen werden dabei beispielsweise gemäß der Norm IEC 61508/IEC61511 auch als Sicherheitsanforderungsstufe, Sicherheitsstufe oder Sicherheits-Integritätslevel (englisch "safety-integrity-level", kurz SIL) bezeichnet, wo anhand dieser Begriffe ein Maß für die Beurteilung elektrischer/elektronischer/programmierbarer elektronischer (E/E/PE)-Systeme in Bezug auf die Zuverlässigkeit von Sicherheitsfunktionen und -komponenten beschrieben wird.

Ähnliche Ausführungen können auch dem Stand der Technik entnommen werden. So beschreibt die EP 2733718 A2 ein Verfahren und eine Schaltung zur Auswertung von OSSD-Signalen, die von einem sicheren Ausgangselement kommen, in einem sicheren Empfangselement.

In der zitierten Druckschrift wird zwar eine Auswerteschaltung für OSSD-Signale angegeben, es werden jedoch keine weiteren Überlegungen präsentiert, wie anhand eines gegebenen OSSD-Signals oder allgemein anhand eines Diagnosesignals eine weitere Erhöhung des Diagnosedeckungsgrades herbeigeführt werden kann. Angesichts steigender Anforderungen im Bereich der funktionalen Sicherheit ist eine stete Erhöhung des Diagnosedeckungsgrades aber eine oft gestellte und wesentliche Aufgabe. Insbesondere die Diagnose von sicheren Empfangselementen selbst wird im Stand der Technik nicht beschrieben. Demzufolge werden im Stand der Technik auch keine Ansätze beschrieben, die innere, innerhalb von sicheren Empfangselementen liegende Schaltungsteile, explizit mit dem Ziel einer Erhöhung des Diagnosedeckungsgrades in Betracht ziehen. Dieser Umstand stellt eine noch nicht geschlossene Lücke auf dem Gebiet der funktionalen Sicherheit dar. DE102018200120 A1 beschreibt eine Sicherheitssteuerung mit wenigstens einem Halbleiterschaltkontakt.

Es ist deshalb eine Aufgabe der gegenständlichen Erfindung, ein Verfahren zur Erhöhung des Diagnosedeckungsgrades von sicheren elektrischen Empfangselementen anzugeben. Diese Aufgabe wird durch die Merkmale der unabhängigen Ansprüche der gegenständlichen Erfindung gelöst. Dabei wird von einer elektrischen Schaltanordnung mit zumindest zwei Kanälen ausgegangen, welche jeweils eine den jeweiligen Kanal versorgende elektrische Quelle unter Ausbildung einer elektrischen Versorgungsgröße mit einem Ausgang des jeweiligen Kanals elektrisch leitend verbinden, wobei der Schaltanordnung ein externes Sicherheitssignal zugeführt wird, aus welchem für die zumindest zwei Kanäle jeweils ein internes Sicherheitssignal erzeugt wird, um damit einen seriell in den jeweiligen Kanal geschalteten Spannungsunterbrecher anzusteuern.

Erfindungsgemäß ist für eine derartige Schaltanordnung vorgesehen, den internen Sicherheitssignalen ein gepulstes Diagnosesignal, in welchem sich ein erster Diagnose-Signalpegel und ein zweiter Diagnose-Signalpegel abwechseln, zur Ausbildung von zwei sich in den internen Sicherheitssignalen abwechselnden Sicherheits-Signalpegeln zu überlagern, um die in die jeweiligen Kanäle geschalteten Spannungsunterbrecher durch Ansteuerung mit dem ersten Sicherheits-Signalpegel zu öffnen und durch Ansteuerung mit dem zweiten Sicherheits-Signalpegel zu schließen und damit die sich in den jeweiligen Kanälen einstellenden Versorgungsgrößen jeweils abwechselnd zu unterbrechen.

Unter "abwechselnd unterbrechen" der sich in den jeweiligen Kanälen einstellenden Versorgungsgrößen ist hierbei die Herbeiführung einer zeitlichen Abfolge von zumindest zwei Versorgungsgrößen-Signalpegeln in den jeweiligen, sich in den jeweiligen Kanälen einstellenden Versorgungsgrößen zu verstehen. Das kann bedeuten, dass die jeweiligen Versorgungsgrößen durch das abwechselnde Unterbrechen zuerst einen ersten Versorgungsgrößen-Signalpegel annehmen, danach einen zweiten, anderen Versorgungsgrößen-Signalpegel annehmen, danach wieder den ersten Versorgungsgrößen-Signalpegel annehmen usw. Im Fall von als Spannungen gegebenen Versorgungsgrößen kann sich der erste Versorgungsgrößen-Signalpegel als gleich einer die elektrische Schaltanordnung versorgenden Versorgungsspannung ergeben, und der zweite Versorgungsgrößen-Signalpegel gleich einem der elektrischen Schaltanordnung zugewiesenen Bezugspotential sein. Die durch das abwechselnde Unterbrechen herbeigeführten, zumindest zwei sich abwechselnden Versorgungsgrößen-Signalpegel können aber auch andere Werte annehmen. In vielen Fällen kann es in diesem Zusammenhang von Vorteil sein, wenn die jeweiligen, sich in den jeweiligen Kanälen einstellenden Versorgungsgrößen synchron abwechselnd unterbrochen werden. Werden die sich in den jeweiligen Kanälen einstellenden Versorgungsgrößen synchron abwechselnd unterbrochen werden, werden die Änderungen von einem ersten Versorgungsgrößen-Signalpegel zu einem zweiten Versorgungsgrößen-Signalpegel in den Versorgungsgrößen der jeweiligen Kanäle jeweils zu gleichen Zeitpunkten herbeigeführt.

Allerdings ist auch eine asynchrone abwechselnde Unterbrechung der Versorgungsgrößen denkbar, wobei die Änderungen von einem ersten Versorgungsgrößen-Signalpegel zu einem zweiten Versorgungsgrößen-Signalpegel in den jeweiligen Versorgungsgrößen jeweils zu voneinander verschiedenen Zeitpunkten herbeigeführt werden. In manchen Fällen ist auch eine komplementäre abwechselnde Unterbrechung der sich in den in den jeweiligen Kanälen einstellenden Versorgungsgrößen denkbar. Bei einer komplementären abwechselnden Unterbrechung der jeweiligen Versorgungsgrößen kann einer ersten Versorgungsgröße immer dann ein erster Versorgungsgrößen-Signalpegel zugewiesen werden, wenn eine zweite Versorgungsgröße einen zweiten Versorgungsgrößen-Signalpegel aufweist, und der ersten Versorgungsgröße immer dann der zweite Versorgungsgrößen-Signalpegel zugewiesen werden, wenn die zweite Versorgungsgröße den ersten Versorgungsgrößen-Signalpegel aufweist. Eine komplementäre abwechselnde Unterbrechung der Versorgungsgrößen kann ebenfalls synchron oder asynchron gestaltet sein.

Davon ausgehend ist erfindungsgemäß vorgesehen, die abwechselnd unterbrochenen Versorgungsgrößen als Messgrößen messtechnisch zu erfassen und die erfassten Messgrößen der abwechselnd unterbrochenen Versorgungsgrößen miteinander zu vergleichen, um zur Überwachung der elektrischen Schaltanordnung eine Abweichung zwischen den erfassten Messgrößen zu ermitteln. In einer besonders vorteilhaften Weise kann als Diagnosesignal, das den internen Sicherheitssignalen überlagert wird, ein außerhalb der zu überwachenden Schaltanordnung generiertes, also ein externes, Diagnosesignal herangezogen werden. So können externe Diagnosesignale zur internen Überwachung in sicheren, elektrischen Schaltanordnungen herangezogen werden, wodurch insbesondere der erreichbare Diagnosedeckungsgrad erhöht werden kann.

Besondere Bedeutung kommt bei der oben beschriebenen Vorgehensweise der Messung der übertragenen Versorgungsgrößen zu. Vorteilhafterweise wird eine Messung der übertragenen Versorgungsgrößen hierbei so vorgenommen, dass Änderungen in den Versorgungsgrößen durch die erfassten Messgrößen zuverlässig wiedergegeben werden. Eine Messung der übertragenen Versorgungsgrößen kann hierbei analog, aber auch digital durchgeführt werden. Erfolgt die Messung der Versorgungsgrößen digital, ist eine Abtastung der zu messenden Versorgungsgrößen erforderlich. Bei einer digitalen Messung der Versorgungsgrößen und demnach einer Abtastung der Versorgungsgrößen kommt insbesondere der Wahl der Messzeitpunkte, an denen gemessen wird, Bedeutung zu, da sicherzustellen ist, dass Änderungen in den Versorgungsgrößen durch die an den Messzeitpunkten erfassten Messgrößen auch wiedergegeben werden können. In einer vorteilhaften Weise können die abwechselnd unterbrochenen Versorgungsgrößen zu diesem Zweck jeweils zu zumindest einem Messzeitpunkt gemessen werden, an dem das Diagnosesignal den ersten Signalpegel aufweist. Zusätzlich ist es vielfach vorteilhaft, die abwechselnd unterbrochenen Versorgungsgrößen zusätzlich jeweils auch zu zumindest einem Messzeitpunkt zu messen, an dem das Diagnosesignal den zweiten Signalpegel aufweist. Eine weitere vorteilhafte Wahl der Messzeitpunkte kann in diesem Zusammenhang überdies erfolgen, indem zumindest ein Messzeitpunkt gewählt wird, welcher innerhalb einer steigenden oder einer fallenden Flanke des Diagnosesignals liegt, wobei in einer steigenden Flanke des Diagnosesignals ein Übergang des Diagnosesignals vom ersten Signalpegel zum zweiten Signalpegel und in einer fallenden Flanke des Diagnosesignals ein Übergang des Diagnosesignals vom zweiten Signalpegel zum ersten Signalpegel erfolgt. Auf die beschriebene Weise können in den Kanälen auftretende Änderungen zuverlässig erfasst werden.

Im Fall einer analogen Messung der zu messenden Versorgungsgrößen müssen keine Überlegungen hinsichtlich zu wählender Messzeitpunkte angestellt werden. Da bei einer analogen Messung nicht zu ausgewählten, diskreten Abtastzeitpunkten gemessen wird, sondern die Messung kontinuierlich erfolgt, sind bei einer analogen Messung auch jene Zeitpunkte, an denen Änderungen in den Versorgungsgrößen stattfinden oder zu erwarten sind, automatisch miterfasst. Aus diesem Grund kann im Rahmen der gegenständlichen Erfindung vielfach auch eine analoge Messung vorteilhaft eingesetzt werden.

Wird eine Abweichung zwischen den erfassten Messgrößen festgestellt, von der auf eine Fehlfunktion in einem der Kanäle geschlossen werden kann, kann in einer vorteilhaften Weise geeignet auf diesen Umstand reagiert werden, indem die Ausgänge der zumindest zwei Kanäle stromlos gemacht werden. Um einen stromlosen Zustand an den Ausgängen der Kanäle zu erreichen, können in einer vorteilhaften Weise die in den Kanälen vorgesehenen Spannungsunterbrecher geöffnet werden, die an den Ausgängen der Kanäle abfallenden Ausgangsspannungen, welche im Fall der Versorgung einer Treiberschaltung durch die Schaltanordnung z.B. erzeugten Treiber-Versorgungsspannungen entsprechen können, durch einen zur Einstellung der Ausgangsspannungen vorgesehenen Spannungssteller zu Null gebracht werden oder die elektrische Quelle zur Versorgung der Kanäle deaktiviert wird. Die konkrete Ausgestaltung einer Maßnahme, um den Ausgang eines Kanals stromlos zu machen, ist hierbei nicht entscheidend, vielmehr ist wichtig, dass eine Erkenntnis über eine mögliche Fehlfunktion in einem Kanal geeignet in das Sicherheitskonzept der Schaltanordnung eingebunden wird.

Im Normalbetrieb, wenn also keine Fehlfunktionen in den erfindungsgemäß diagnostizierten Kanälen gegeben sind, ist es darüber hinaus in vielen Fällen von Vorteil, den Einfluss des zur erfindungsgemäßen Diagnose eingesetzten Diagnosesignals durch geeignete Zusatzmaßnahmen weiter zu reduzieren. Dazu kann in einer vorteilhaften Weise in den Kanälen zumindest ein Filterelement angeordnet werden, um die Versorgungsgrößen zu glätten, insbesondere durch eine mittels des zumindest einen Filterelements herbeigeführte Tiefpassfilterung der Versorgungsgrößen.

Durch das erfindungsgemäße Verfahren wird es möglich, Komponenten einer Diagnose und damit einer Überwachung zugänglich zu machen, für die das im Rahmen von aus dem Stand der Technik beschriebenen Verfahren nicht möglich war. Gerade dieser Unterschied stellt eine wichtige Verbesserung gegenüber aus dem Stand der Technik bekannten Verfahren dar. Das erfindungsgemäße Prinzip der Verwendung externer Diagnosesignale auch zur internen Testung sicherer Empfangselemente kann dabei generell im Bereich der funktionalen Sicherheit angewandt werden.

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
Fig. 1 eine sichere Ansteuerung einer elektrischen Last in Form eines Blockschaltbildes,
Fig. 2 eine schematische Darstellung einer erfindungsgemäßen Schaltanordnung, reduziert auf die für das erfindungsgemäße Verfahren notwendigen Komponenten,
Fig. 2a eine Möglichkeit zur Überlagerung eines Sicherheitssignals mit einem externen Diagnosesignal,
Fig. 3 eine vorteilhafte Ausgestaltung einer erfindungsgemäßen Schaltanordnung,
Fig. 4 Signalverläufe im Fall eines Fehlers und
Fig. 5 Signalverläufe im Normalbetrieb.

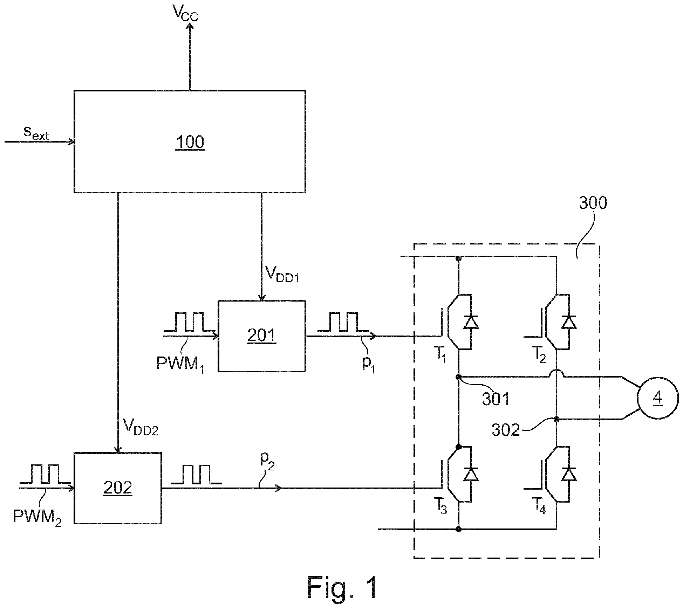

Fig. 1 zeigt eine sichere Ansteuerung einer elektrischen Last 4, wie sie bei einer Anwendung der Sicherheitsfunktion STO üblich ist. In der in Fig. 1 gezeigten Schaltung werden die Treiberbausteine 201 und 202 dazu genutzt, um die als PWM-Signale gegebenen Ansteuersignale PWM₁ und PWM₂ auf die Schaltsignale p₁ und p₂ zu übertragen, welche wiederum die Halbleiterschalter T₁ bis T₄ ansteuern und diese entsprechend den Ansteuersignalen PWM₁ und PWM₂ öffnen und schließen. Die Treiberbausteine 201 und 202 können dabei in bekannter Weise als diskrete oder integrierte Schaltungen umgesetzt sein, wobei anstelle des Begriffs "Treiberbaustein" auch die Bezeichnung "Gatetreiber" üblich ist. Zur galvanischen Trennung werden in Treiberbausteinen oftmals Optokoppler vorgesehen. Eine galvanische Trennung muss aber nicht zwangsläufig durch Optokoppler erfolgen, auch induktive, kapazitive und andere Trennungen sind hierfür möglich. In Fällen, in denen eine galvanische Trennung nicht erforderlich ist, kann auf diese auch gänzlich verzichtet werden.

Grundsätzlich wird für jeden Halbleiterschalter T₁ bis T₄ ein eigener Treiberbaustein genutzt, der jeweils durch eine Treiberversorgungsspannung V_{DD1} bzw. V_{DD2} versorgt wird. Fig. 1 stellt diesbezüglich aus Gründen der Übersichtlichkeit lediglich die Treiberbausteine 201 und 202 dar. Die Treiberversorgungsspannungen V_{DD1} und V_{DD2} werden im gezeigten Fall von der Schaltanordnung 100 bereitgestellt, wozu die Schaltanordnung 100 wiederum von einer Quelle mit der Versorgungsspannung Vcc versorgt wird. Insbesondere in Schaltanordnungen wie der in Fig. 1 gezeigten Schaltanordnung 100 kann das erfindungsgemäße Verfahren vorteilhaft angewandt werden. Um eine Anwendung des erfindungsgemäßen Verfahrens in der gezeigten Schaltanordnung 100 zu ermöglichen, wird im gegenständlichen Fall das externe Sicherheitssignal sₑₓₜ in die Schaltanordnung 100 geführt.

Die Sicherheitsfunktion STO ("STO-Funktion") basiert darauf, dass ein, beispielsweise von einem Regler ausgegebenes, Impulssignal PWM zwar an einen Treiberbaustein 201, 202 weitergegeben wird, die Energieversorgung der Treiberbausteine 201, 202, beispielsweise durch die Versorgungsspannungen V_{DD1}, V_{DD2}, aber unterbrochen wird, wenn die STO-Funktion aktiviert wird, wodurch das PWM-Signal nicht weitergegeben werden kann. Eine derartige Unterbrechung kann im gezeigten Fall durch die Schaltanordnung 100 erfolgen. Als Impulssignale PWM₁, PWM₂ können unterschiedlichste Signalmodulationen zur Anwendung kommen. Nur beispielhaft und nicht weiter einschränkend seien die Pulsweiten-/ Pulsbreitenmodulation, Pulsdauermodulation und die Pulsfrequenzmodulation genannt.

Wie weiters in Fig. 1 erkennbar ist, wird zur Ansteuerung der elektrischen Last 4 in bekannter Weise ein Wechselrichter 300 mit einer Halbbrücke je Phase genutzt, hier beispielsweise mit einer ersten Halbbrücke, bestehend aus den Halbleiterschaltern T₁ und T₃, und einer zweiten Halbbrücke, bestehend aus den Halbleiterschaltern T₂ und T₄, für eine beispielhafte, zweiphasige elektrische Last 4. Die elektrische Last 4 ist im gezeigten Fall mit einem ersten Knotenpunkt 301 und einem zweiten Knotenpunkt 302 verbunden. Die Knotenpunkte 301 und 302 sind dabei so angeordnet, dass der erste Knotenpunkt 301 zwischen den zwei Halbleiterschaltern T₁ und T₃ liegt, der zweite Knotenpunkt 302 zwischen den beiden Halbleiterschaltern T₂ und T₄ liegt. Jeder Halbleiterschalter T₁ bis T₄ wird dabei, wie oben beschrieben, von einem eigenen Treiberbaustein angesteuert. Da die grundlegende Funktionsweise eines Wechselrichters 300 hinlänglich bekannt ist, wird hier nicht näher darauf eingegangen. Selbstverständlich können die elektrische Last 4 und der Wechselrichter 300 auch mit einer anderen Phasenanzahl realisiert sein.

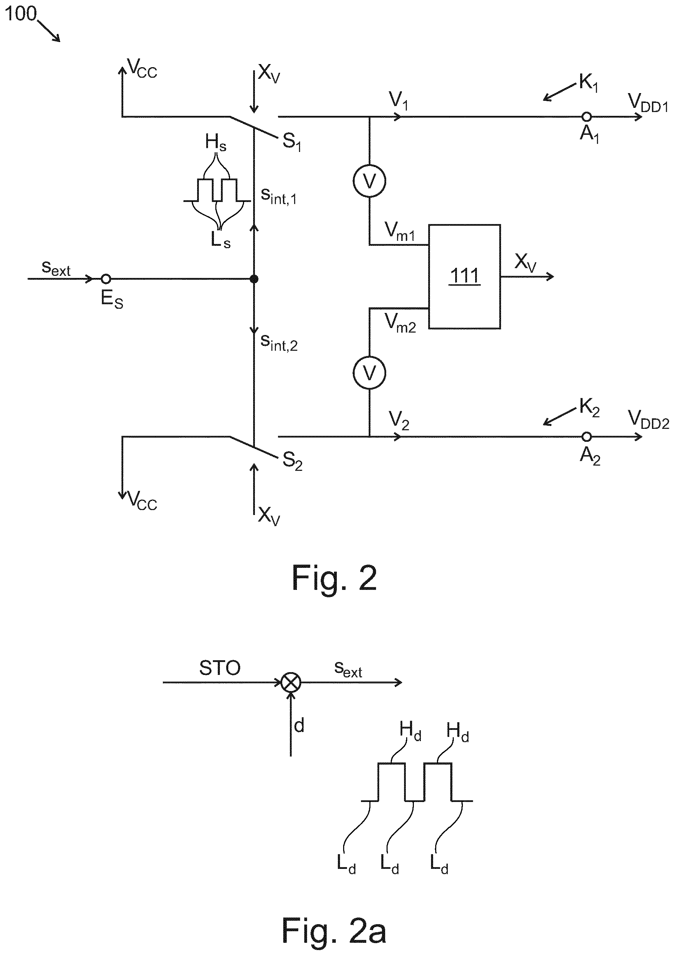

Fig. 2 zeigt eine, auf die für eine Anwendung des erfindungsgemäßen Verfahrens erforderlichen Bauteile reduzierte, schematische Darstellung der in Fig. 1 gezeigten Schaltanordnung 100. Grundsätzlich kann die gezeigte Schaltanordnung 100 hierbei selbst ein sicheres Eingangselement darstellen, oder aber ein Bestandteil eines sicheren Eingangselements sein, neben weiteren Bestandteilen des sicheren Eingangselements. Weitere Bestandteile können dabei z.B. durch Schnittstellen zu weiteren, sicheren sowie nicht sicheren Geräten gegeben sein, oder auch Ein- und/oder Ausgabeelementen zur Kommunikation mit einem Bediener entsprechen. Ein sicheres Eingangselement kann z.B. durch eine Steuereinheit eines zu überwachenden technischen Systems gegeben sein, wie durch eine SPS ("Speicherprogrammierbare Steuerung"), eine Sicherheits-SPS, eine Umrichter-Steuerung oder einen Kompaktumrichter mit integrierter Steuerung, usw. Für eine Anwendung des erfindungsgemäßen Verfahrens in einer Schaltanordnung 100 ist wesentlich, dass in der Schaltanordnung 100 zumindest zwei Kanäle K₁ und K₂ vorgesehen sind, welche jeweils von einer elektrischen Quelle mit einer Versorgungsspannung Vcc versorgt werden, dass die Kanäle K₁ und K₂ je eine elektrische Versorgungsgröße V₁, V₂ von der elektrischen Quelle hin zu einem Ausgang A_{1,} A₂ des jeweiligen Kanals übertragen, beispielsweise um eine Treiber-Versorgungsspannung wie V_{DD1} oder V_{DD2} bereitzustellen, und dass die Schaltanordnung 100 ausgestaltet ist, um ein externes Sicherheitssignal sₑₓₜ aufzunehmen, welches insbesondere ein STO-Signal transportieren kann. Die sich dabei in den Kanälen einstellenden Versorgungsgrößen V₁, V₂ können hierbei beispielsweise durch elektrische Ströme oder durch elektrische Spannungen gegeben sein.

In einer vorteilhaften Ausführung der gegenständlichen Erfindung kann ein externes Sicherheitssignal sₑₓₜ auch zur Umsetzung einer anderen Sicherheitsfunktionen beitragen, also beispielsweise ein SS1-Signal oder ein SS2-Signal oder ein SOS-Signal oder ein SLS-Signal oder ein SSM-Signal oder ein SSR-Signal oder ein SLP-Signal oder ein SP-Signal oder ein SDI-Signal oder ein SBC/SBT-Signal oder ein weiteres Signal der funktionalen Sicherheit transportieren. Die genannten Sicherheitssignale, und dabei insbesondere STO-Signale, sind dabei bevorzugt so gestaltet, dass ein hoher Signalpegel ("H-Pegel", "High-Pegel", z.B. 24V oder 10V oder 5V) eine fehlerfreie Situation repräsentiert, ein niedriger Signalpegel ("L-Pegel", "Low-Pegel", z.B. 0V) demgegenüber einen Fehler. Durch diese Wahl lassen sich insbesondere auch Ausfälle der Versorgung eines sicheren Ausgangselements oder Kabelbrüche detektieren.

Das externe Sicherheitssignal sₑₓₜ wird in der in Fig. 2 gezeigten Situation über die Eingangsschnittstelle Eₛ von der Schaltanordnung 100 aufgenommen. Aus dem externen Sicherheitssignal sₑₓₜ werden in der Folge die internen Sicherheitssignale s_{int,1} und s_{int,2} erzeugt, wobei im gegenständlichen Zusammenhang unter der Erzeugung von internen Sicherheitssignalen s_{int,1} und s_{int,2} allgemein die Generierung / Bereitstellung von internen Sicherheitssignalen s_{int,1}, s_{int,2} in Abhängigkeit des externen Sicherheitssignals sₑₓₜ zu verstehen ist. Darunter fällt einerseits die direkte Verknüpfung des externen Sicherheitssignals sₑₓₜ mit Signalleitungen für die internen Sicherheitssignale s_{int,1} und s_{int,2}, wie in Fig. 2 gezeigt, andererseits aber auch die Generierung von internen Sicherheitssignalen s_{int,1} und s_{int,2} auf Basis einer galvanischen Entkopplung zwischen internen und externen Sicherheitssignalen. Eine galvanische Entkopplung kann hierbei beispielsweise mithilfe von Optokopplern erreicht werden. Transportiert das externe Sicherheitssignal sₑₓₜ wie oben beschrieben ein STO-Signal, überträgt sich dieses STO-Signal bei deren Erzeugung auch auf die internen Sicherheitssignale s_{int,1} und s_{int,2} und wird demnach auch Teil der internen Sicherheitssignale s_{int,1} und s_{int,2}. Dies bedeutet insbesondere, dass Pegeländerungen in einem externen Sicherheitssignal sₑₓₜ auf Pegeländerungen in den internen Sicherheitssignale s_{int,1} und s_{int,2} abgebildet werden.

Die internen Sicherheitssignale s_{int,1} und s_{int,2} werden in weiterer Folge zu den Spannungsunterbrechern S₁, S₂ geleitet und dort zur Ansteuerung der Spannungsunterbrechern S₁, S₂ eingesetzt. Die Spannungsunterbrecher S₁, S₂ stellen dabei jeweils einen zentralen Bestandteil der Kanäle K₁, K₂ dar. Bevorzugt sind die in den Kanälen K₁, K₂ vorgesehenen Spannungsunterbrecher S₁, S₂ als Halbleiterschalter ausgeführt, beispielsweise in Form von Längs-MOSFETs, oder in Form von IGBTs oder anderen Halbleiterschaltern. Der primäre Zweck der Spannungsunterbrecher S₁, S₂ liegt darin, in den Kanälen K₁, K₂ eine leitende elektrische Verbindung zwischen der die Versorgungsspannung Vcc bereitstellenden elektrischen Quelle und den Ausgängen A_{1,} A₂ herzustellen, und diese Verbindung bei Bedarf, insbesondere wenn eine Sicherheitsfunktion auslöst, wieder trennen zu können. Die Spannungsunterbrecher S₁, S₂ werden zu diesem Zweck durch internen Sicherheitssignale s_{int,1} und s_{int,2} angesteuert und entsprechend geöffnet oder geschlossen. Üblicherweise sind in den internen Sicherheitssignal s_{int,1}, s_{int,2} zu diesem Zweck ein erster, niedriger Sicherheits-Signalpegel Lₛ sowie ein zweiter, hoher Sicherheits-Signalpegel Hₛ vorgesehen. Liegt in der in Fig. 2 gezeigten Situation der hohe, zweite Sicherheits-Signalpegel Hₛ an den Spannungsunterbrechern S₁, S₂ an, werden diese geschlossen, liegt demgegenüber der niedrige Sicherheits-Signalpegel Lₛ an den Spannungsunterbrechern S₁, S₂ an, werden diese geöffnet. Wie erwähnt ergeben sich diese Sicherheits-Signalpegel Lₛ, Hₛ in Abhängigkeit der Signalpegel des externen Sicherheitssignals sₑₓₜ, aus welchem die internen Sicherheitssignale s_{int,1}, s_{int,2} erzeugt werden. Signalisiert ein Low-Pegel im externen Sicherheitssignal sₑₓₜ beispielsweise einen Fehler oder eine Anforderung einer Sicherheitsfunktion durch einen Benutzer oder Bediener, wird dieser Low-Pegel auf einen niedrigen Sicherheits-Signalpegel Lₛ in den Sicherheitssignalen s_{int,1}, s_{int,2} abgebildet, der in der Folge die Spannungsunterbrecher S₁, S₂ öffnet. In einer bevorzugten Ausführungsform besitzen die Pegel eines externen Sicherheitssignals sₑₓₜ und die eines internen Sicherheitssignals sᵢₙₜ die gleiche Pegelhöhe, dies ist für die Anwendung der gegenständlichen Erfindung allerdings nicht zwingend erforderlich.

Erfindungsgemäß ist für die gezeigte Schaltanordnung 100 vorgesehen, die internen Sicherheitssignale s_{int,1}, s_{int,2} jedoch nicht nur zur Umsetzung einer Sicherheitsfunktion, wie STO, einzusetzen, sondern diese Signale ebenso zu Diagnose- und Überwachungszwecken heranzuziehen. Dazu wird den internen Sicherheitssignale s_{int,1}, s_{int,2} ein höherfrequentes Diagnosesignal d überlagert. Diese Vorgehensweise steht in einem klaren Gegensatz zu aus dem Stand der Technik bekannten Verfahren, wo Diagnosesignale d, wie z.B. die genannten externen OSSD-Signale, üblicherweise daran gehindert werden, in das Innere einer sicheren Schaltanordnung 100 zu gelangen. Sind Diagnosesignale d bereits Teil eines eingehenden Sicherheitssignals sₑₓₜ, beispielsweise weil ein Diagnosesignal d bereits außerhalb einer Schaltanordnung 100 einem externen Sicherheitssignal sₑₓₜ überlagert worden ist, werden diese im Stand der Technik nach Möglichkeit am Eingang einer sicheren Schaltanordnung 100 aus dem eingehenden Sicherheitssignal sₑₓₜ gefiltert. Die oft höherfrequenten Diagnosesignale d werden im Stand der Technik auf diese Weise daran gehindert, in das Innere einer sicheren Schaltanordnung 100 zu gelangen, womit versucht wird, unerwünschte Querwirkungen und negative Beeinflussungen der Funktionsweise der Schaltanordnung 100 durch höherfrequente Diagnosesignale d zu unterbinden. Umso erstaunlicher ist es, dass durch den bewussten Einsatz von höherfrequenten Diagnosesignalen d im Inneren einer sicheren Schaltanordnungen 100 der Diagnosedeckungsgrad einer derartigen Schaltanordnung 100 im Gegenteil dazu gerade erhöht werden kann und so die Robustheit, die Zuverlässigkeit und folglich auch die Funktionsweise einer Schaltanordnung 100 insgesamt verbessert werden kann.

Um die beschriebene Verwendung von internen Sicherheitssignale s_{int,1}, s_{int,2} zu Diagnose-und Überwachungszwecken zu realisieren, ist erfindungsgemäß vorgesehen, in den Sicherheitssignalen s_{int,1}, s_{int,2} durch die Überlagerung eines gepulsten Diagnosesignal d einen gepulsten Signalanteil vorzusehen. Ein solches Diagnosesignal d ist hierbei bevorzugt durch ein (externes) OSSD-Signal gegeben, welches bevorzugt von einem (externen) sicheren Ausgangselement, wie einem Sicherheitssensor, oder einem Sicherheitslichtgitter oder einer Lichtschranke, bereitgestellt wird. Im Rahmen der gegenständlichen Erfindung wird von einem Diagnosesignal d ausgegangen, in welchem sich ein erster Diagnose-Signalpegel L_{d} und ein zweiter Diagnose-Signalpegel H_{d} abwechseln. Dieser Wechsel zwischen erstem Diagnose-Signalpegel L_{d} und zweitem Diagnose-Signalpegel H_{d} kann auch als Abfolge von OSSD-Testpulsen aufgefasst werden. Wie erwähnt sind typische Werte für OSSD-Testpulse beispielsweise eine Pulsdauer von ≤ 1,0 ms und eine Periodendauer ≥ 500 ms. Auch an dieser Stelle gilt, dass die Diagnose-Signalpegel H_{d}, L_{d}, die Sicherheits-Signalpegel Hₛ, Lₛ sowie die Pegel eines externen Sicherheitssignals, beispielsweise STO-Pegel, gleich sein können. Dies stellt aber keine Voraussetzung für eine Anwendung der gegenständlichen Erfindung dar.

In einer vorteilhaften Weise kann die Überlagerung eines gepulsten Diagnosesignals d auf ein internes Sicherheitssignal s_{int,1}, s_{int,2} erfolgen, indem ein externes, gepulstes Diagnosesignal d bereits mit dem externen Sicherheitssignal sₑₓₜ, aus dem die internen Sicherheitssignale s_{int,1}, s_{int,2} erzeugt werden, mittransportiert wird. Solche Situationen treten auf, wenn beispielsweise einem STO-Signal ein gepulstes Diagnosesignal d überlagert wird, was bereits in einem sicheren Ausgangselement erfolgen kann. Eine solche Überlagerung kann dabei in einer vorteilhaften Weise durch eine Multiplikation eines STO-Signals mit einem Diagnosesignal d erreicht werden, wobei der Begriff "Überlagerung" nicht als einschränkend aufzufassen ist. Je nach konkretem Anwendungsfall kann es ebenso zielführend sein, die Signale zu addieren, sie miteinander zu falten, oder die zu überlagernden Signale auf eine andere Art zu verknüpfen. Die Umsetzung dieses Schrittes anhand einer Multiplikation ist schematisch in Fig. 2a dargestellt. Die so resultierende, gepulste Form der internen Sicherheitssignale s_{int,1} und s_{int,2} ist in Fig. 2 anhand der neben den Signalpfeilen angeordneten Impulszüge qualitativ angedeutet. Im Rahmen der gegenständlichen Erfindung ist es allerdings ebenso denkbar, ein Diagnosesignal über einen separaten Signaleingang in eine Schaltanordnung 100 zu führen und erst in der Schaltanordnung 100 die Überlagerung des Diagnosesignals d auf die internen Sicherheitssignale s_{int,1}, s_{int,2} vorzunehmen, beispielsweise anhand einer Multiplikation eines externen Signals sₑₓₜ mit dem Diagnosesignal d. In beiden Varianten führen der erste Diagnose-Signalpegel L_{d} und der zweite Diagnose-Signalpegel H_{d}, die sich im Diagnosesignal d abwechseln, zur Ausbildung von zwei sich in den internen Sicherheitssignalen s_{int,1}, s_{int,2} abwechselnden Sicherheits-Signalpegeln Hₛ, Lₛ.

Die internen Sicherheitssignale s_{int,1}, s_{int,2}, in denen sich entsprechend den obigen Ausführungen der erste Diagnose-Signalpegel L_{d} und der zweite Diagnose-Signalpegel H_{d} abwechseln, werden nun erfindungsgemäß herangezogen, um die in den Kanälen K₁, K₂ vorgesehenen Spannungsunterbrecher S₁, S₂ in einer den sich abwechselnden ersten Diagnose-Signalpegeln L_{d} und zweiten Diagnose-Signalpegeln H_{d} entsprechenden Weise anzusteuern und die Spannungsunterbrecher S₁, S₂ damit durch Ansteuerung mit dem ersten Sicherheits-Signalpegel Lₛ zu öffnen und durch Ansteuerung mit dem zweiten Sicherheits-Signalpegel Hₛ wieder zu schließen. Sind die Spannungsunterbrecher S₁, S₂ geschlossen, entsteht in den Kanälen K₁, K₂ eine elektrische leitende Verbindung zwischen der angeschlossenen Versorgungsspannung Vcc und den Ausgängen A_{1,} A₂ der Kanäle K₁, K₂, an denen die Treiber-Versorgungsspannungen V_{DD1} und V_{DD2} ausgegeben werden. Sind die Spannungsunterbrecher S₁, S₂ geöffnet, ist diese Verbindung getrennt, was sich in unmittelbarer Weise auf die sich in den Kanälen K₁, K₂ einstellenden/ergebenden Versorgungsgrößen V₁, V₂ auswirkt. Es entstehen abwechselnd unterbrochene Versorgungsgrößen V₁, V₂.

Wie bereits ausgeführt, ist unter "abwechselnd unterbrechen" der sich in den jeweiligen Kanälen K₁, K₂ einstellenden Versorgungsgrößen V₁, V₂ die Herbeiführung einer zeitlichen Abfolge von zumindest zwei Versorgungsgrößen-Signalpegeln in den jeweiligen, sich in den jeweiligen Kanälen einstellenden Versorgungsgrößen V₁, V₂ zu verstehen. Das kann bedeuten, dass die jeweiligen Versorgungsgrößen V₁, V₂ durch das abwechselnde Unterbrechen durch das Schalten der Spannungsunterbrecher S₁, S₂ zuerst einen ersten Versorgungsgrößen-Signalpegel annehmen, danach einen zweiten, anderen Versorgungsgrößen-Signalpegel annehmen, danach wieder den ersten Versorgungsgrößen-Signalpegel annehmen usw. Hierbei kann der erste Versorgungsgrößen-Signalpegel der die elektrische Schaltanordnung 100 versorgenden Versorgungsspannung Vcc entsprechen, und der zweiten Versorgungsgrößen-Signalpegel gleich dem der elektrischen Schaltanordnung 100 zugewiesenen Bezugspotential. Wie ebenso bereits eingangs ausgeführt, können die durch das abwechselnde Unterbrechen herbeigeführten, zumindest zwei sich abwechselnden Versorgungsgrößen-Signalpegel aber auch anders gewählt werden.

Zur Umsetzung der erfindungsgemäßen Überwachung und/oder Diagnose der Schaltanordnung 100 werden die in den Kanälen K₁ und K₂ vorliegenden Versorgungsgrößen V₁, V₂ in einem weiteren Schritt messtechnisch erfasst, was in der in Fig. 2 gezeigten Situation anhand der beiden Schaltzeichen für ein Spannungsmessgerät dargestellt ist. Aus dieser Messung gehen die Messgrößen Vₘ₁ und Vₘ₂ hervor. Eine derartige Messung kann, wie aus der Messtechnik hinlänglich bekannt, in Form einer diskreten Abtastung erfolgen, beispielsweise mit einer Abtastrate von mehr als 100Hz, oder einer Abtastrate von mehr als 1kHz, oder aber auch mit einer Abtastrate von mehr als 10kHz. Die genannten Messungen können allerdings auch analog erfolgen.

Bei Durchführung des erfindungsgemäßen Verfahrens auf Basis einer diskreten Messung und damit diskreten Abtastung ist eine geeignete Wahl von Messzeitpunkten Tₘ von Bedeutung, an denen die Messung der Versorgungsgrößen V₁, V₂ durchgeführt wird. Bei der Wahl von Messzeitpunkten Tₘ ist es erforderlich sicherzustellen, dass die Änderungen der Versorgungsgrößen V₁, V₂, die durch die nun gepulsten internen Sicherheitssignale s_{int,1}, s_{int,2} herbeigeführt werden, auch tatsächlich durch die Messung erfasst werden und demnach in den erfassten Messgrößen Vₘ₁, Vₘ₂ abgebildet sind. Das kann erreicht werden, indem die pulsweise unterbrochenen Versorgungsgrößen V₁, V₂ jeweils zu zumindest einem Messzeitpunkt Tₘ gemessen werden, an dem das Diagnosesignal d den ersten Diagnose-Signalpegel L_{d} aufweist. Es kann allerdings vorteilhaft sein, die pulsweise unterbrochenen Versorgungsgrößen V₁, V₂ jeweils zu zumindest einem weiteren Messzeitpunkt Tₘ zu messen, an dem das Diagnosesignal d den zweiten Diagnose-Signalpegel H_{d} aufweist. Weiters ist es oftmals von Vorteil, eine Messung in den Flanken der internen Sicherheitssignale s_{int,1}, s_{int,2} durchzuführen. Dies kann erreicht werden, indem zumindest ein Messzeitpunkt Tₘ, an dem die pulsweise unterbrochenen Versorgungsgrößen V₁, V₂ gemessen werden, innerhalb einer steigenden oder einer fallenden Flanke des Diagnosesignals d gelegt wird, wobei in der steigenden Flanke des Diagnosesignals d ein Übergang des Diagnosesignals d vom ersten Diagnose-Signalpegel L_{d} zum zweiten Diagnose-Signalpegel H_{d} und in der fallenden Flanke des Diagnosesignals d ein Übergang des Diagnosesignals d vom zweiten Diagnose-Signalpegel H_{d} zum ersten Diagnose-Signalpegel L_{d} erfolgt.

Wie bereits ausgeführt, sind im Fall einer analogen Messung der zu messenden Versorgungsgrößen V₁, V₂ keine Überlegungen hinsichtlich zu wählender Messzeitpunkte Tₘ erforderlich. Da bei einer analogen Messung nicht zu ausgewählten, diskreten Abtastzeitpunkten gemessen wird, sondern die Messung kontinuierlich erfolgt, sind bei einer analogen Messung auch jene Zeitpunkte Änderungen in den Versorgungsgrößen stattfinden oder zu erwarten sind, automatisch erfasst. Aus diesem Grund kann sich im Rahmen der gegenständlichen Erfindung eine analoge Messung vielfach als vorteilhaft erweisen.

Die genannten Messgrößen Vₘ₁ und Vₘ₂ werden in einem weiteren Schritt miteinander verglichen, wobei in der Folge von einer Abweichung der Messgrößen Vₘ₁ und Vₘ₂ auf eine Fehlfunktion in einem der Kanäle K₁, K₂ geschlossen werden kann. Der erfindungsgemäße Vergleich der Messgrößen Vₘ₁ und Vₘ₂ kann beispielsweise anhand einer Differenzbildung oder anhand einer Division erfolgen. Zur Bewertung der Abweichung zwischen Messgrößen wie Vₘ₁ und Vₘ₂ kann in einer vorteilhaften Weise eine Abweichungsschwelle vorgegeben werden. Eine derartige Abweichungsschwelle kann beispielsweise in Form eines Absolutwertes vorgegeben werden. Im Fall einer elektrischen Spannung kann der Absolutwert beispielsweise 10V, oder bevorzugt 1V, oder ebenfalls bevorzugt 0,1V betragen, den die Differenz oder der Quotient der Messsignale Vₘ₁ und Vₘ₂ oder der Absolutwert der Differenz oder des Quotienten der Messsignale Vₘ₁ und Vₘ₂ nicht überschreiten darf. Im Fall von als elektrischen Strömen vorliegenden Versorgungsgrößen V₁, V₂ können für den Absolutwert auch 10A, oder bevorzugt 1A, oder ebenfalls bevorzugt 0,1A herangezogen werden. Ebenso ist es denkbar, als Abweichungsschwelle einen Relativwert vorzugeben, der beispielsweise einen prozentualen Anteil eines der Messgrößen Vₘ₁ und Vₘ₂ beschreibt, die deren Abweichung nicht überschreiten darf. Bevorzugt können für einen derartigen Relativwert 10%, oder 1%, oder 0,1% verwendet werden.

In einer bevorzugten Ausführung der gegenständlichen Erfindung wird bei der Erzeugung der internen Sicherheitssignale s_{int,1} und s_{int,2} ebenso dafür Sorge getragen, dass auch deren Abweichung untereinander, die ebenso anhand einer Differenzbildung oder anhand einer Division ermittelt werden kann, stets möglichst gering ist, oder zumindest unter einer vorgegebenen Abweichungsschwelle liegt. Auch zu diesem Zweck kann eine Abweichungsschwelle beispielsweise in Form eines Absolutwertes vorgegeben werden. Im Fall von Sicherheitssignalen s_{int,1} und s_{int,2} in Form von elektrischen Spannungen kann dieser Absolutwert beispielsweise als 10V, oder bevorzugt als 1V, oder ebenfalls bevorzugt als 0,1V vorgegeben werden. Im Fall von elektrischen Strömen können hingegen wiederum 10A, oder bevorzugt 1A, oder ebenfalls bevorzugt 0,1A herangezogen werden. Auch hier ist es ebenso denkbar, als Abweichungsschwelle einen Relativwert vorzugeben, der beispielsweise einen prozentualen Anteil eines der internen Sicherheitssignale s_{int,1} und s_{int,2} beschreibt, die deren Abweichung nicht überschreiten darf. Bevorzugt können für diesen Relativwert 10%, oder 1%, oder 0,1% verwendet werden.

In der in Fig. 2 gezeigten Ausführung erfolgt der beschriebene Vergleich zwischen den Messgrößen Vₘ₁ und Vₘ₂ in der Diagnoseeinheit 111. Mögliche Realisierungen derartiger digitaler Diagnoseeinheiten 111 sind dabei unter anderem durch mikroprozessorbasierte Hardware, Mikrocontroller und integrierte Schaltungen (ASIC, FPGA) gegeben.

Findet die Messung analog statt, kann der erfindungsgemäße Vergleich beispielsweise durch eine Diagnoseeinheit 111 in Form eines aus der elektronischen Schaltungstechnik hinlänglich bekannten Komparators durchgeführt werden.

Der erfindungsgemäße Vergleich der Messgrößen Vₘ₁ und Vₘ₂ dient der Detektion von Unterschieden in den Versorgungskanälen K₁, K₂, welche sich in Form von voneinander abweichenden Messgrößen Vₘ₁, Vₘ₂ äußern. Aus einer erkannten Abweichung zwischen den Messgrößen Vₘ₁ und Vₘ₂ kann auf Fehler, insbesondere bei den Spannungsunterbrechern S₁, S₂ selbst, in deren Verbindung zur elektrischen Quelle, welche die Versorgungsspannung V_{cc} bereitstellt, oder an einer anderen Stelle in den Kanälen K₁, K₂, geschlossen werden kann. Ein derartiger Vergleich sollte stets derart gestaltet sein, dass geringe/vernachlässigbare Unterschiede zwischen den verglichenen Messgrößen Vₘ₁, Vₘ₂, welche unter anderem aufgrund von Bauteiltoleranzen oder Messrauschen entstehen können, toleriert werden. Gleichzeitig sollen aber bei Fehlerfällen in einem der beiden Kanäle K₁, K₂ die resultierenden Unterschiede als solche detektiert werden können und eine entsprechende Reaktion ausgelöst werden. Als entsprechende Reaktion ist hierbei insbesondere die Herbeiführung eines stromlosen Zustandes an den Ausgängen A_{1,} A₂ der Kanäle K₁, K₂ zu verstehen. An dieser Stelle weiß der mit einer spezifischen Situation betraute Sicherheitsfachmann allerdings Bescheid, wie derartige teils stark einzelfallabhängigen Vergleiche zu gestalten sind.

Wie erläutert, werden die Messgrößen Vₘ₁ und Vₘ₂ miteinander verglichen, beispielsweise anhand einer Differenzbildung oder anhand einer Division, um Fehlfunktionen in den Kanälen K₁, K₂, beispielsweise bei den Spannungsunterbrechern S₁, S₂ selbst, in deren Verbindung zur Versorgungsspannung V_{cc} oder an einer anderen Stelle in den Kanälen K₁, K₂, zu detektieren. Wird eine Fehlfunktion detektiert, können als Schutz- und/oder Sicherheitsmaßnahme beispielsweise die Spannungsunterbrecher S₁, S₂ geöffnet werden, und die Schaltanordnung 100 in einen sicheren Zustand versetzt werden. Als sicherer Zustand kann dabei ein Zustand der Schaltanordnung 100 verstanden werden, in dem die gemäß einem Sicherheitskonzept definierten Schutzziele realisiert sind und demnach keine Gefahr für Mensch und/oder Umwelt droht. Dies wird insbesondere dadurch erreicht, dass die Ausgänge A_{1,} A₂ der Kanäle K₁, K₂ stromlos gemacht werden.

Eine mögliche Umsetzung dieser Vorgehensweise ist in Fig. 2 gezeigt, wo die Diagnoseeinheit das Abschaltsignal Xv ausgibt. Bei der in Fig. 2 gezeigten, beispielhaften Realisierungsvariante der gegenständlichen Erfindung wird das Abschaltsignal Xv mit den Spannungsunterbrechern S₁, S₂ verbunden, und dem Abschaltsignal Xv einen Low-Pegel zur Öffnung der Spannungsunterbrecher S₁, S₂ zugewiesen, wenn ein Vergleich der Messgrößen Vₘ₁ und Vₘ₂ eine Abweichung und damit einen zuvor genannten Fehler in einem der Kanäle K₁, K₂ ergibt. Grundsätzlich können im Fehlerfall aber auch andere Maßnahmen zur Fehlerbehandlung in einer oftmals vorteilhaften Weise eingesetzt werden, solange dadurch sichergestellt wird, dass dadurch die Ausgänge A₁, A₂, der gegebenen Kanäle K₁, K₂, stromlos gemacht werden.

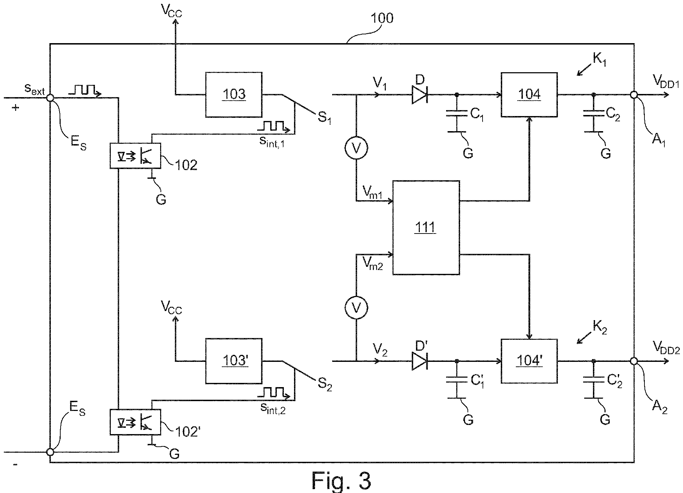

Fig. 3 zeigt eine mögliche Ausführungsform der erfindungsgemäßen Schaltanordnung in einem höheren Detailgrad. Dabei umfasst die in Fig. 3 dargestellte Schaltanordnung 100 einen differentiellen Eingang mit galvanisch getrennten Übertragern, konkret in Form von Optokopplern 102, 102', welche die Erzeugung der internen Sicherheitssignale s_{int,1}, s_{int,2} aus dem externen Sicherheitssignal sₑₓₜ bewerkstelligen. Das Bezugspotential der dargestellten Schaltung ist hierin mit G ("Ground") bezeichnet.

Im Unterschied zur Ausführung aus Fig. 2 zeigt Fig. 3 zusätzlich die Blöcke 103, 103', die stellvertretend für geeignete elektrotechnische Vorrichtungen zur Verbindung der Kanäle K₁, K₂ mit der Versorgungsspannung V_{cc} stehen. Weiters sind im Unterschied zu Fig. 2 die Dioden D, D' vorgesehen, um im Fehlerfall eine gegebenenfalls schadhafte Stromumkehr zu verhindern. Die Kondensatoren C₁, C₂, C₁', C₂' sowie die Blöcke 104, 104' dienen als Filterelemente insbesondere einer Glättung / Aufbereitung / Konditionierung der erzeugten Treiber-Versorgungsspannungen V_{DD1}, V_{DD2}. Auf diese Bauteile wird nachfolgend gesondert eingegangen. Auch in der in Fig. 3 gezeigten Ausführungsform werden ein gepulstes externes Diagnosesignal d und ein Sicherheitssignal, wie ein STO-Signal, bereits außerhalb der Schaltanordnung 100 miteinander verknüpft, woraus das externe Sicherheitssignal sₑₓₜ hervorgeht.

Wie erwähnt ist es vom erfindungsgemäßen Verfahren gewünscht, dass der Einsatz von Diagnosesignalen d und deren Überlagerung über interne Sicherheitssignale s_{int,1}, s_{int,2} die mit den Sicherheitssignalen s_{int,1}, s_{int,2} verknüpften Sicherheitsfunktionen sowie den Normalbetrieb des diagnostizierten technischen Systems nicht beeinträchtigt. Diese Forderung muss umso mehr berücksichtigt werden, wenn externe Diagnosesignale d, wie externe OSSD-Testpulse, nicht wie aus dem Stand der Technik bekannt nur für die Testung externer Sicherheitskomponenten verwendet werden, sondern entsprechend der gegenständlichen Erfindung in ein sicheres Empfangselement, wie die gegenständliche Schaltanordnung 100, geleitet werden und dort zu Diagnosezwecken auch Einfluss auf leistungsübertragende Kanäle K₁, K₂ nehmen.

Aus diesem Grund sieht Fig. 3 weiters eine Spannungspufferung in den Kanälen K₁, K₂ vor, wobei die Spannungspufferung in der in Fig. 3 gezeigten Ausführungsform anhand der Kapazitäten C₁, C₂ bzw. C₁', C₂' erfolgt. Grundsätzlich können aber auch andere Arten von Energiespeichern zu diesem Zweck als Filterelemente verwendet werden, wie Induktivitäten in Form von Drosseln. Um eine nachfolgende, unerwünschte Beeinflussung beispielsweise eines versorgten Treiberbausteines 201, 202 sicher zu vermeiden, ist es vorteilhaft, diese Energiespeicher so auszulegen, dass Low-Pulse in den Versorgungsgrößen V₁, V₂, welche durch Diagnose-Low-Pulse (Abschnitte im Diagnosesignal d mit niedrigem Diagnose-Signalpegel L_{d}) mit einer maximal zulässigen Zeitdauer verursacht werden, überbrückt werden. Eine derartige maximal zulässige Zeitdauer legt hierbei fest, wie lange ein Diagnose-Low-Puls zu Diagnosezwecken maximal sein darf. Ziel der oben genannten Auslegung der Filterelemente ist, dass erst bei Low-Pulsen in den Versorgungsgrößen V₁, V₂ deren Dauer diese maximale Dauer überschreitet, eine Auswirkung auf die ausgegebenen Treiber-Versorgungsspannungen V_{DD1}, V_{DD2} ersichtlich / zugelassen wird. Auf diese Weise kann eine unerwünschte Beeinflussung der Treiber-Versorgungsspannungen V_{DD1}, V_{DD2} vermieden werden, ohne dass jedoch die Wirkung der Spannungsunterbrecher S₁, S₂, beispielsweise in einem STO-Fehlerfall, beeinträchtigt würde. Überdies können zu lange Low-Pulse in den Versorgungsgrößen V₁, V₂ ebenfalls ein Indiz auf einen Fehler in der Schaltanordnung 100 sein, auch wenn zu lange Diagnose-Low-Pulse in den Kanälen K₁, K₂ synchron auftreten.

Eine weitere diesbezügliche Verbesserung wird in der in Fig. 3 gezeigten Situation durch die Blöcke 104 und 104' ermöglicht. In einer bevorzugten Ausführungsform können die Blöcke 104 und 104' als Spannungssteller umgesetzt werden, die die bereits durch die Kapazitäten C₁, C₂ bzw. C₁', C₂' geglätteten Spannungsverläufe zusätzlich nachregeln und die erzeugten Ausgangsspannungen V_{DD1} und V_{DD2} auf einen vorgegebenen Sollwert einstellen. Als Spannungssteller 104, 104' ist dabei insbesondere eine elektrische / elektronische Schaltung / Vorrichtung zu verstehen, die in der Lage ist, die ausgegebenen Spannung, hier V_{DD1} und V_{DD2}, einem gewünschten Sollwert nachzuführen. In einem Spannungssteller 104, 104' kann dabei auch eine Messung der ausgegebenen Spannung, hier V_{DD1} und V_{DD2}, erfolgen, die anschließend wie in der Regelungstechnik üblich, als Istwert in einem Regelkreis zurückgeführt wird. Zur Stellung der ausgegebenen Spannung V_{DD1}, V_{DD2} können die Spannungssteller 104, 104' beispielsweise wie ein Gleichspannungswandler auf das periodische Schalten eines periodisch arbeitenden elektronischen (Halbleiter-)Schalters zurückgreifen. Auf diese Weise kann der Einfluss von gemäß den Pulsen eines Diagnosesignals d geöffneten und geschlossenen Spannungsunterbrechern S₁, S₂ zusätzlich reduziert werden. Die Blöcke 104, 104', aber auch die die Kapazitäten C₁, C₂ bzw. C₁', C₂' können demnach als Filterelemente aufgefasst werden, die die Versorgungsgrößen V₁, V₂ glätten.

Im Fall einer Realisierung der Blöcke 104 und 104' als Spannungssteller ergibt sich eine weitere, wichtige Option zur Reaktion auf einen im Rahmen der Diagnose erkannten Fehler in einem der Kanäle K₁, K₂. So können im Fall einer erkannten Fehlfunktion die Ausgangsspannungen V_{DD1} und V_{DD2} auch anhand der Spannungssteller 104 und 104' zu Null gebracht werden und die Ausgänge A_{1,} A₂ so stromlos gemacht werden. Diese Methode zur Fehlerbehandlung ist besonders dann vorteilhaft, wenn anhand der zuvor durchgeführten Diagnose ein Fehler in einem der Spannungsunterbrecher S₁, S₂ erkannt wurde. Ein Öffnen der Spannungsunterbrecher S₁, S₂ wäre in einem solchen Fall nicht möglich. Daneben ist aber ebenso denkbar, die Ausgänge A_{1,} A₂ der zumindest zwei Kanäle K₁, K₂ stromlos zu machen, indem die elektrische Quelle, die die Versorgungsspannung V_{cc} zur Versorgung der Kanäle K₁, K₂, bereitstellt, deaktiviert wird.

Im Unterschied zum bekannten Stand der Technik werden gemäß der gegenständlichen Erfindung externe Diagnosesignale d, wie OSSD-Testpulse, die von einem sicheren Ausgangsgerät erzeugt werden, wie von einer Lichtschranke, einem Sicherheitslichtgitter usw., im Inneren der Schaltanordnung 100 weiterverwendet. OSSD-Lowpulse werden demnach am Eingang nicht wie ansonsten üblich weggefiltert, sondern über die Spannungsunterbrecher S₁, S₂ in die beiden Kanäle K₁, K₂ übernommen. Bis zu den Messstellen, an denen die Messgrößen Vₘ₁, Vₘ₂ erfasst werden, sind die Kanäle K₁, K₂ sehr dynamisch aufgebaut, in dem Sinne, dass Frequenzanteile der Diagnosesignale d bis 100Hz, bevorzugt bis 1kHz, oder besonders bevorzugt bis 10kHz ohne nennenswerte Verzerrung anhand der Messgrößen Vₘ₁, Vₘ₂ erfasst werden können. Erst nach den Messstellen erfolgt entsprechend der obigen Beschreibung eine Filterung, wobei insbesondere die Low-Pulse der internen Sicherheitssignale s_{int,1}, s_{int,2} aus den Versorgungsgrößen gefiltert werden. Bis zu den Spannungsunterbrechern S₁, S₂ werden die durch das Diagnosesignal d vorgegebenen OSSD-Testpulse jedoch möglichst ungefiltert übertragen.

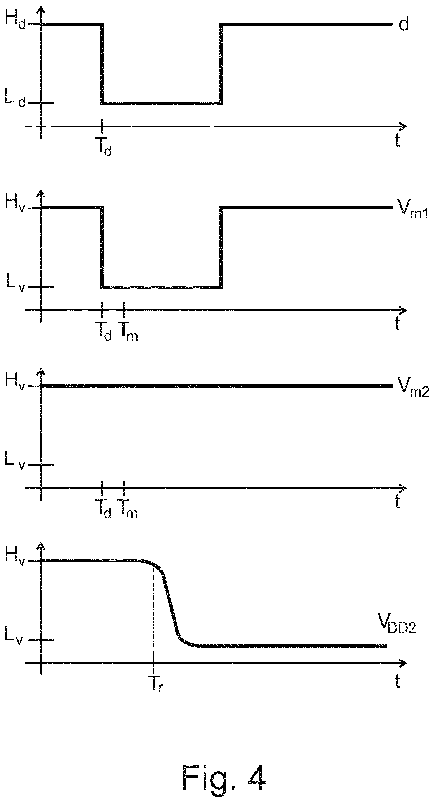

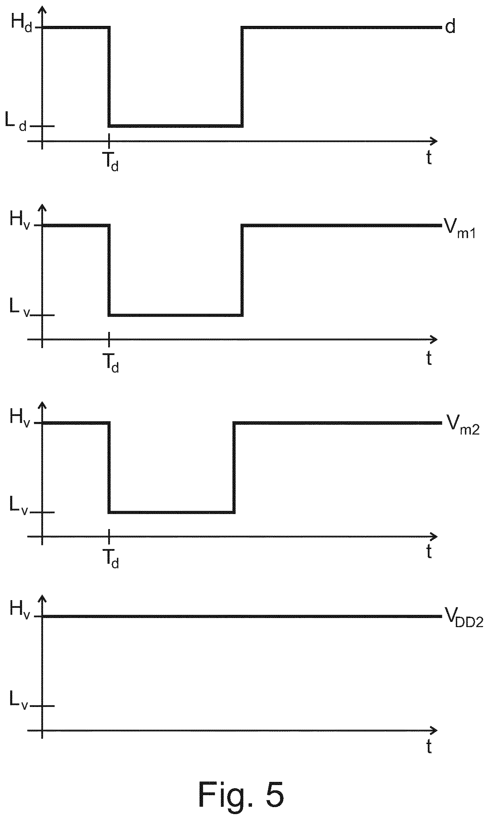

Signalverläufe, wie sie im Zuge der Anwendung des erfindungsgemäßen Verfahrens in der in Fig. 3 gezeigten Schaltung auftreten können, sind in Fig. 4 und Fig. 5 dargestellt. Die dargestellten Signale d, Vₘ₁, Vₘ₂ und V_{DD2} bewegen sich dabei innerhalb von für sie gegebenen High-Pegeln (H_{d}, Hv) und Low-Pegeln (L_{d}, Lv). Die jeweiligen High-Pegel H_{d}, Hv können dabei je nach Anwendungsfall gleich, aber auch unterschiedlich sein. Selbes gilt für die Low-Pegel L_{d}, Lv. Konkret zeigt Fig. 4 zunächst zum Diagnosezeitpunkt T_{d} eine fallende Flanke des dargestellten Diagnosesignals d, was eine ebenso fallende Flanke der internen Sicherheitssignale s_{int,1}, s_{int,2} zur Folge hat. Das dargestellte Messsignal Vₘ₁ folgt diesem Verlauf auch, woraus auf einen intakten ersten Kanal K₁ geschlossen werden kann. Der Verlauf der Messgröße Vₘ₂ lässt jedoch auf einen Defekt im Versorgungskanal K₂ schließen, da in diesen Verläufen die fallende Flanke nicht umgesetzt wird. Dieser Umstand wird zum Reaktionszeitpunkt Tᵣ auch erkannt, wonach die Versorgung umgehend unterbrochen wird, und die Versorgungsgrößen V_{DD1} und V_{DD2} (nur V_{DD2} dargestellt) durch einen Spannungssteller 104, 104' auf den niedrigen Pegel Lv gezogen werden.

Im Gegenteil dazu zeigt Fig. 5 Signalverläufe, wie sie sich bei intakten Versorgungskanälen K₁, K₂ bzw. bei einer generell intakten Schaltanordnung 1 ergeben. Beide Messgrößen Vₘ₁ und Vₘ₂ folgen hier der durch die internen Sicherheitssignale s_{int,1}, s_{int,2} aufgrund des gezeigten Diagnosesignals d vorgegebenen fallenden und steigenden Flanken. Anhand von Fig. 5 kann überdies erkannt werden, dass es aufgrund der beschriebenen Spannungspufferung zu keiner Beeinträchtigung der erzeugten Ausgangsgrößen V_{DD1} und V_{DD2} kommt.

Zu den anhand des erfindungsgemäßen Verfahrens diagnostizierbaren Fehlern gehören unter anderem Fehler in der Versorgungsspannung Vcc, Fehler an den Spannungsunterbrechern S₁, S₂, Fehler in den Leitern der Versorgungskanäle K₁, K₂, aber auch Fehler z.B. in den Optokopplern 102, 102' anhand derer die internen Sicherheitssignale s_{int,1}, s_{int,2} erzeugt werden. Dadurch, dass diese Fehler aufgedeckt werden können, kann der Diagnosedeckungsgrad merklich erhöht werden. Somit sind bei gleichem Hardware-Aufwand bessere Sicherheitskennwerte möglich.

Im Vergleich zum bekannten Stand der Technik ist im Rahmen der gegenständlichen Erfindung überdies keine eigene, zusätzliche Schaltung zur Erzeugung von Testpulsen erforderlich. Vielfach werden Versorgungsgrößen in Versorgungskanälen überdies von vornherein gemessen und überwacht. Zu diesem Zweck bereits vorgesehene Auswerteeinheiten können dann in einer besonders vorteilhaften Weise auch zur Umsetzung des erfindungsgemäßen Verfahrens herangezogen werden. Generell kann durch die erfindungsgemäße Art der Diagnose und Testung ein höherer Diagnosedeckungsgrad erreicht werden. Dadurch kann das Verhältnis von erreichtem Sicherheitslevel zu erforderlichem Hardwareaufwand verbessert werden und damit oftmals teure und aufwendige redundante Sicherheitskomponenten vermieden werden.

## Patentansprüche

1. Verfahren zur Überwachung einer elektrischen Schaltanordnung (100) mit zumindest zwei Kanälen (K₁, K₂), welche jeweils eine den jeweiligen Kanal (K₁, K₂) versorgende elektrische Quelle (V_{cc}) unter Ausbildung einer elektrischen Versorgungsgröße (V₁, V₂) mit einem Ausgang (A_{1,} A₂) des jeweiligen Kanals (K₁, K₂) elektrisch leitend verbinden, wobei der Schaltanordnung (100) ein externes Sicherheitssignal (sₑₓₜ) zugeführt wird, aus welchem für die zumindest zwei Kanäle (K₁, K₂) jeweils ein internes Sicherheitssignal (s_{int,1}, s_{int,2}) erzeugt wird, um damit einen seriell in den jeweiligen Kanal (K₁, K₂) geschalteten Spannungsunterbrecher (S₁, S₂) anzusteuern, **dadurch gekennzeichnet, dass** den internen Sicherheitssignalen (s_{int,1}, s_{int,2}) ein gepulstes Diagnosesignal (d), in welchem sich ein erster Diagnose-Signalpegel (L_{d}) und ein zweiter Diagnose-Signalpegel (H_{d}) abwechseln, zur Ausbildung von zwei sich in den internen Sicherheitssignalen (s_{int,1}, s_{int,2}) abwechselnden Sicherheits-Signalpegeln (Hₛ, Lₛ) überlagert wird, um die in die jeweiligen Kanäle (K₁, K₂) geschalteten Spannungsunterbrecher (S₁, S₂) durch Ansteuerung mit dem ersten Sicherheits-Signalpegel (Lₛ) zu öffnen und durch Ansteuerung mit dem zweiten Sicherheits-Signalpegel (Hₛ) zu schließen und damit die sich in den jeweiligen Kanälen (K₁, K₂) einstellenden Versorgungsgrößen (V₁, V₂) jeweils abwechselnd zu unterbrechen, **dass** die abwechselnd unterbrochenen Versorgungsgrößen (V₁, V₂) als Messgrößen (Vₘ₁, Vₘ₂) messtechnisch erfasst werden **und dass** die erfassten Messgrößen (Vₘ₁, Vₘ₂) der abwechselnd unterbrochenen Versorgungsgrößen (V₁, V₂) miteinander verglichen werden, um zur Überwachung der elektrischen Schaltanordnung (100) eine Abweichung zwischen den erfassten Messgrößen (Vₘ₁, Vₘ₂) zu ermitteln.

2. Verfahren nach Anspruch 1, **dadurch gekennzeichnet, dass** die abwechselnd unterbrochenen Versorgungsgrößen (V₁, V₂) jeweils zu zumindest einem Messzeitpunkt (Tₘ) gemessen werden, an dem das Diagnosesignal (d) den ersten Diagnose-Signalpegel (L_{d}) aufweist.

3. Verfahren nach Anspruch 2, **dadurch gekennzeichnet, dass** die abwechselnd unterbrochenen Versorgungsgrößen (V₁, V₂) jeweils zu zumindest einem Messzeitpunkt (Tₘ) gemessen werden, an dem das Diagnosesignal (d) den zweiten Diagnose-Signalpegel (H_{d}) aufweist.

4. Verfahren nach einem der vorhergehenden Ansprüche, **dadurch gekennzeichnet, dass** zumindest ein Messzeitpunkt (Tₘ), an dem die abwechselnd unterbrochenen Versorgungsgrößen (V₁, V₂) gemessen werden, innerhalb einer steigenden oder einer fallenden Flanke des Diagnosesignals (d) liegt, wobei in der steigenden Flanke des Diagnosesignals (d) ein Übergang des Diagnosesignals (d) vom ersten Diagnose-Signalpegel (L_{d}) zum zweiten Diagnose-Signalpegel (H_{d}) und in der fallenden Flanke des Diagnosesignals (d) ein Übergang des Diagnosesignals (d) vom zweiten Diagnose-Signalpegel (H_{d}) zum ersten Diagnose-Signalpegel (L_{d}) erfolgt.

5. Verfahren nach einem der vorhergehenden Ansprüche, **dadurch gekennzeichnet, dass** die Ausgänge (A₁, A₂) der zumindest zwei Kanäle (K₁, K₂) stromlos gemacht werden, falls die Abweichung der erfassten Messgrößen (Vₘ₁, Vₘ₂) der Versorgungsgrößen (V₁, V₂) eine vorgegebene Abweichungsschwelle überschreitet.

6. Verfahren nach Anspruch 5, **dadurch gekennzeichnet, dass** die Ausgänge (A_{1,} A₂) der zumindest zwei Kanäle (K₁, K₂) stromlos gemacht werden, indem die in den Kanälen (K1, K2) vorgesehenen Spannungsunterbrecher (S₁, S₂) geöffnet werden.

7. Verfahren nach Anspruch 5, **dadurch gekennzeichnet, dass** die Ausgänge (A₁, A₂) der zumindest zwei Kanäle (K₁, K₂) stromlos gemacht werden, indem die an den Ausgängen (A_{1,} A₂) der Kanäle (K₁, K₂) abfallenden Ausgangsspannungen (V_{DD1}, V_{DD2}) durch einen zur Einstellung der Ausgangsspannungen (V_{DD1}, V_{DD2}) vorgesehenen Spannungssteller (104, 104') zu Null gebracht werden.

8. Verfahren nach Anspruch 5, **dadurch gekennzeichnet, dass** die Ausgänge (A_{1,} A₂) der zumindest zwei Kanäle (K₁, K₂) stromlos gemacht werden, indem die elektrische Quelle (V_{cc}) zur Versorgung der Kanäle (K₁, K₂) deaktiviert wird.

9. Verfahren nach einem der vorhergehenden Ansprüche, **dadurch gekennzeichnet, dass** die elektrischen Versorgungsgrößen (V₁, V₂) durch ein in den Kanälen (K₁, K₂) der elektrischen Schaltanordnung (100) angeordnetes Filterelement geglättet werden.

10. Elektrische Schaltanordnung (100) mit zumindest zwei Kanälen (K₁, K₂), welche jeweils eine den jeweiligen Kanal (K₁, K₂) versorgende elektrische Quelle (V_{cc}) unter Ausbildung einer elektrischen Versorgungsgröße (V₁, V₂) mit einem Ausgang (A_{1,} A₂) des jeweiligen Kanals (K₁, K₂) elektrisch leitend verbinden, einer Diagnoseeinheit (111) und einer Eingangsschnittstelle (Eₛ), wobei die Eingangsschnittstelle (Eₛ) ausgestaltet ist, ein externes Sicherheitssignal (sₑₓₜ) aufzunehmen, aus welchem für die zumindest zwei Kanäle (K₁, K₂) je ein internes Sicherheitssignal (s_{int,1}, s_{int,2}) erzeugt wird, um einen seriell in den jeweiligen Kanal (K₁, K₂) geschalteten Spannungsunterbrecher (S₁, S₂) anzusteuern, **dadurch gekennzeichnet, dass** die Schaltanordnung (100) ausgestaltet ist, die internen Sicherheitssignale (s_{int,1}, s_{int,2}) mit einem gepulsten Diagnosesignal (d), in welchem sich ein erster Diagnose-Signalpegel (L_{d}) und ein zweiter Diagnose-Signalpegel (H_{d}) abwechseln, zur Ausbildung von zwei sich in den internen Sicherheitssignalen (s_{int,1}, s_{int,2}) abwechselnden Sicherheits-Signalpegeln (Hₛ, Lₛ) zu überlagern und die in die jeweiligen Kanäle (K₁, K₂) geschalteten Spannungsunterbrecher (S₁, S₂) durch Ansteuerung mit dem ersten Sicherheits-Signalpegel (Lₛ) zu öffnen und durch Ansteuerung mit dem zweiten Sicherheits-Signalpegel (Hₛ) zu schließen, um die sich in den jeweiligen Kanäle (K₁, K₂) einstellenden Versorgungsgrößen (V₁, V₂) jeweils abwechselnd zu unterbrechen, **und dass** die Diagnoseeinheit (111) ausgestaltet ist, die abwechselnd unterbrochenen Versorgungsgrößen (V₁, V₂) als Messgrößen (Vₘ₁, Vₘ₂) messtechnisch zu erfassen und die erfassten Messgrößen (Vₘ₁, Vₘ₂) der abwechselnd unterbrochenen Versorgungsgrößen (V₁, V₂) miteinander zu vergleichen, um zur Überwachung der elektrischen Schaltanordnung (100) eine Abweichung zwischen den erfassten Messgrößen (Vₘ₁, Vₘ₂) zu ermitteln.

## Claims

1. Method for monitoring an electrical switching arrangement (100) having at least two channels (K₁, K₂), which each electrically conductively connect an electrical source (V_{cc}) supplying the respective channel (K₁, K₂), forming an electrical supply quantity (V₁, V₂), to an output (A₁, A₂) of the respective channel (K₁, K₂), wherein an external safety signal (sₑₓₜ) is fed to the switching arrangement (100), from which external safety signal an internal safety signal (s_{int,1}, s_{int,2}) is respectively generated for the at least two channels (K₁, K₂) in order to therewith control a voltage interrupter (S₁, S₂) connected in series in the respective channel (K₁, K₂), **characterized in that** the internal safety signals (s_{int,1}, s_{int,2}) are superimposed with a pulsed diagnostic signal (d), in which a first diagnostic signal level (L_{d}) and a second diagnostic signal level (H_{d}) alternate, in order to form two safety signal levels (Hₛ, Lₛ) which alternate in the internal safety signals (s_{int,1}, s_{int,2}), in order to open the voltage interrupters (S₁, S₂) connected in the respective channels (K₁, K₂) by controlling with the first safety signal level (Lₛ) and to close them by controlling with the second safety signal level (Hₛ) and to thus respectively alternately interrupt the supply quantities (V₁, V₂) appearing in the respective channels (K₁, K₂), **in that** the alternately interrupted supply quantities (V₁, V₂) are measured as measurement quantities (Vₘ₁, Vₘ₂), **and in that** the detected measurement quantities (Vₘ₁, Vₘ₂) of the alternately interrupted supply quantities (V₁, V₂) are compared to one another in order to determine a deviation between the detected measurement quantities (Vₘ₁, Vₘ₂) for monitoring the electrical switching arrangement (100).

2. Method according to Claim 1, **characterized in that** the alternately interrupted supply quantities (V₁, V₂) are each measured at at least one measurement point in time (Tₘ) at which the diagnostic signal (d) has the first diagnostic signal level (L_{d}).

3. Method according to Claim 2, **characterized in that** the alternately interrupted supply quantities (V₁, V₂) are each measured at at least one measurement point in time (Tₘ) at which the diagnostic signal (d) has the second diagnostic signal level (H_{d}).

4. Method according to one of the preceding claims, **characterized in that** at least one measurement point in time (Tₘ) at which the alternately interrupted supply quantities (V₁, V₂) are measured is within a rising or a falling edge of the diagnostic signal (d), wherein a transition of the diagnostic signal (d) from the first diagnostic signal level (L_{d}) to the second diagnostic signal level (H_{d}) takes place in the rising edge of the diagnostic signal (d), and a transition of the diagnostic signal (d) from the second diagnostic signal level (H_{d}) to the first diagnostic signal level (L_{d}) takes place in the falling edge of the diagnostic signal (d).

5. Method according to one of the preceding claims, **characterized in that** the outputs (A₁, A₂) of the at least two channels (K₁, K₂) are de-energized if the deviation of the detected measurement quantities (Vₘ₁, Vₘ₂) of the supply quantities (V₁, V₂) exceeds a specified deviation threshold.

6. Method according to Claim 5, **characterized in that** the outputs (A₁, A₂) of the at least two channels (K₁, K₂) are de-energized by the voltage interrupters (S₁, S₂) provided in the channels (K1, K2) being opened.

7. Method according to Claim 5, **characterized in that** the outputs (A₁, A₂) of the at least two channels (K₁, K₂) are de-energized by the output voltages (V_{DD1}, V_{DD2}) dropping at the outputs (A₁, A₂) of the channels (K₁, K₂) being brought to zero by means of a voltage regulator (104, 104') provided for adjusting the output voltages (V_{DD1}, V_{DD2}).

8. Method according to Claim 5, **characterized in that** the outputs (A₁, A₂) of the at least two channels (K₁, K₂) are de-energized by the electrical source (V_{cc}) for supplying the channels (K₁, K₂) being deactivated.

9. Method according to one of the preceding claims, **characterized in that** the electrical supply quantities (V₁, V₂) are smoothed by a filter element arranged in the channels (K₁, K₂) of the electrical switching arrangement (100).

10. Electrical switching arrangement (100) having at least two channels (K₁, K₂), which each electrically conductively connect an electrical source (V_{cc}) supplying the respective channel (K₁, K₂), forming an electrical supply quantity (V₁, V₂), to an output (A₁, A₂) of the respective channel (K₁, K₂), having a diagnostic unit (111) and an input interface (Eₛ), wherein the input interface (Eₛ) is designed to accept an external safety signal (sₑₓₜ), from which an internal safety signal (s_{int,1}, s_{int,2}) is respectively generated for the at least two channels (K₁, K₂) in order to control a voltage interrupter (S₁, S₂) connected in series in the respective channel (K₁, K₂), **characterized in that** the switching arrangement (100) is designed to superimpose the internal safety signals (s_{int,1}, s_{int,2}) with a pulsed diagnostic signal (d), in which a first diagnostic signal level (L_{d}) and a second diagnostic signal level (H_{d}) alternate, to form two safety signal levels (Hₛ, Lₛ) which alternate in the internal safety signals (s_{int,1}, s_{int,2}) and to open the voltage interrupters (S₁, S₂) connected in the respective channels (K₁, K₂) by controlling with the first safety signal level (Lₛ) and to close them by controlling with the second safety signal level (Hₛ) in order to respectively alternately interrupt the supply quantities (V₁, V₂) appearing in the respective channels (K₁, K₂), **and in that** the diagnostic unit (111) is designed to measure the alternately interrupted supply quantities (V₁, V₂) as measurement quantities (Vₘ₁, Vₘ₂) and to compare the detected measurement quantities (Vₘ₁, Vₘ₂) of the alternately interrupted supply quantities (V₁, V₂) to one another in order to determine a deviation between the detected measurement quantities (Vₘ₁, Vₘ₂) for monitoring the electrical switching arrangement (100).

## Revendications

1. Procédé permettant de surveiller un agencement de commutation (100) électrique comportant au moins deux canaux (K₁, K₂), lesquels relient de manière électriquement conductrice respectivement une source électrique (V_{cc}) alimentant le canal (K₁, K₂) respectif à une sortie (A₁, A₂) du canal (K₁, K₂) respectif avec formation d'une grandeur d'alimentation (V₁, V₂) électrique, dans lequel un signal de sécurité externe (sₑₓₜ) est acheminé à l'agencement de commutation (100), à partir duquel signal de sécurité respectivement un signal de sécurité interne (s_{int,1}, s_{int,2}) est généré pour les au moins deux canaux (K₁, K₂) afin de commander ainsi un interrupteur de tension (S₁, S₂) monté en série dans le canal (K₁, K₂) respectif, **caractérisé en ce qu'**un signal de diagnostic (d) pulsé, dans lequel sont alternés un premier niveau de signal de diagnostic (L_{d}) et un second niveau de signal de diagnostic (Hd), est superposé aux signaux de sécurité internes (s_{int,1}, s_{int,2}) pour former deux niveaux de signaux de sécurité (Hₛ, Lₛ) alternés dans les signaux de sécurité internes (s_{int,1}, s_{int,2}) afin d'ouvrir les interrupteurs de tension (S₁, S₂) montés dans les canaux (K₁, K₂) respectifs par commande avec le premier niveau de signal de sécurité (Lₛ) et de les fermer par commande avec le second niveau de signal de sécurité (Hₛ) et ainsi d'interrompre respectivement alternativement les grandeurs d'alimentation (V₁, V₂) se réglant dans les canaux (K₁, K₂) respectifs, **en ce que** les grandeurs d'alimentation (V₁, V₂) interrompues alternativement sont détectées selon la technique de la mesure en tant que grandeurs de mesure (Vₘ₁, Vₘ₂), **et en ce que** les grandeurs de mesure (Vₘ₁, Vₘ₂) détectées des grandeurs d'alimentation (V₁, V₂) interrompues alternativement sont comparées l'une à l'autre, afin de déterminer un écart entre les grandeurs de mesure (Vₘ₁, Vₘ₂) détectées pour la surveillance de l'agencement de commutation (100) électrique.

2. Procédé selon la revendication 1, **caractérisé en ce que** les grandeurs d'alimentation (V₁, V₂) interrompues alternativement sont mesurées respectivement à au moins un instant de mesure (Tₘ) auquel le signal de diagnostic (d) présente le premier niveau de signal de diagnostic (L_{d}).

3. Procédé selon la revendication 2, **caractérisé en ce que** les grandeurs d'alimentation (V₁, V₂) interrompues alternativement sont mesurées respectivement à au moins un instant de mesure (Tₘ) auquel le signal de diagnostic (d) présente le second niveau de signal de diagnostic (H_{d}).

4. Procédé selon l'une des revendications précédentes,
**caractérisé en ce qu'au** moins un instant de mesure (Tₘ), auquel les grandeurs d'alimentation (V₁, V₂) interrompues alternativement sont mesurées, se situe dans un flanc montant ou un flanc descendant du signal de diagnostic (d), dans lequel, dans le flanc montant du signal de diagnostic (d), une transition du signal de diagnostic (d) du premier niveau de signal de diagnostic (L_{d}) au second niveau de signal de diagnostic (H_{d}) est effectuée et, dans le flanc descendant du signal de diagnostic (d), une transition du signal de diagnostic (d) du second niveau de signal de diagnostic (H_{d}) au premier niveau de signal de diagnostic (L_{d}) est effectuée.

5. Procédé selon l'une des revendications précédentes,
**caractérisé en ce que** les sorties (A₁, A₂) des au moins deux canaux (K₁, K₂) sont mises hors tension si l'écart des grandeurs de mesure (Vₘ₁, Vₘ₂) détectées des grandeurs d'alimentation (V₁, V₂) dépasse un seuil d'écart prédéfini.

6. Procédé selon la revendication 5, **caractérisé en ce que** les sorties (A₁, A₂) des au moins deux canaux (K₁, K₂) sont mises hors tension en ouvrant les interrupteurs de tension (S₁, S₂) prévus dans les canaux (K1, K2).

7. Procédé selon la revendication 5, **caractérisé en ce que** les sorties (A₁, A₂) des au moins deux canaux (K₁, K₂) sont mises hors tension en amenant les tensions de sortie (V_{DD1}, V_{DD2}) diminuant aux sorties (A₁, A₂) des canaux (K₁, K₂) à zéro au moyen d'un régulateur de tension (104, 104') prévu pour le réglage des tensions de sortie (V_{DD1}, V_{DD2}).

8. Procédé selon la revendication 5, **caractérisé en ce que** les sorties (A₁, A₂) des au moins deux canaux (K₁, K₂) sont mises hors tension en désactivant la source électrique (V_{cc}) permettant l'alimentation des canaux (K₁, K₂).

9. Procédé selon l'une des revendications précédentes,
**caractérisé en ce que** les grandeurs d'alimentation (V₁, V₂) électriques sont lissées par un élément de filtrage disposé dans les canaux (K₁, K₂) de l'agencement de commutation (100) électrique.

10. Agencement de commutation (100) électrique comportant au moins deux canaux (K₁, K₂), lesquels relient de manière électriquement conductrice respectivement une source électrique (V_{cc}) alimentant le canal (K₁, K₂) respectif à une sortie (A₁, A₂) du canal (K₁, K₂) respectif avec formation d'une grandeur d'alimentation (V₁, V₂) électrique, une unité de diagnostic (111) et une interface d'entrée (Eₛ), dans lequel l'interface d'entrée (Eₛ) est configurée pour recevoir un signal de sécurité externe (sₑₓₜ) à partir duquel respectivement un signal de sécurité interne (s_{int,1}, s_{int,2}) est généré pour les au moins deux canaux (K₁, K₂) afin de commander un interrupteur de tension (S₁, S₂) monté en série dans le canal (K₁, K₂) respectif, **caractérisé en ce que** l'agencement de commutation (100) est configuré pour superposer les signaux de sécurité internes (s_{int,1}, s_{int,2}) à un signal de diagnostic (d) pulsé dans lequel sont alternés un premier niveau de signal de diagnostic (L_{d}) et un second niveau de signal de diagnostic (H_{d}) pour former deux niveaux de signaux de sécurité (Hₛ, Lₛ) alternés dans les signaux de sécurité internes (s_{int,1}, s_{int,2}), et pour ouvrir les interrupteurs de tension (S₁, S₂) montés dans les canaux (K₁, K₂) respectifs par commande avec le premier niveau de signal de sécurité (Lₛ) et pour les fermer par commande avec le second niveau de signal de sécurité (Hₛ), afin d'interrompre respectivement alternativement les grandeurs d'alimentation (V₁, V₂) se réglant dans les canaux (K₁, K₂) respectifs, **et en ce que** l'unité de diagnostic (111) est configurée pour détecter selon la technique de la mesure les grandeurs d'alimentation (V₁, V₂) interrompues alternativement en tant que grandeurs de mesure (Vₘ₁, Vₘ₂) et pour comparer les grandeurs de mesure (Vₘ₁, Vₘ₂) détectées des grandeurs d'alimentation (V₁, V₂) interrompues alternativement l'une avec l'autre afin de déterminer un écart entre les grandeurs de mesure (Vₘ₁, Vₘ₂) détectées pour la surveillance de l'agencement de commutation (100) électrique.
